# EUROPEAN PATENT APPLICATION

(11) **EP 2 244 089 A1**
(43) Date of publication of application: **27.10.2010**
(21) Application number: 10004323.1
(22) Date of filing: 23.04.2010
(51) Int. Cl.: G01N 27/22, G01N 33/28, G01R 31/12

(54) **On-line diagnostic and prediction of dielectric behavior of power transformers**

(30) Priority: 24.04.2009 CZ 20090262
(71) Applicant: Altmann, Josef, Domazlice (CZ)
(72) Inventor: Altmann, Josef, Domazlice (CZ)
(74) Representative: Langrova, Irena

(57) **Abstract**

A method and apparatus for on-line diagnostics and the prediction of the dielectric behavior of power transformers uses a Temperature Loading Curve (TLC) method based on the on-line reading of the relative humidity of the oil in the main tank of the transformer, and on-line reading of at least two temperatures of the oil-cellulose system of the transformer by a suitable computer. Data obtained by sensors are subsequently used to evaluate the average water content in the cellulose materials, the Qp-value, and the dielectric characteristic of the transformer, the TLC. The TLC relation then describes its specific dielectric behavior, the change of the Ud-value of transformer oil with temperature, for the whole range of its operational temperatures.

## Description

### Technical Field

The invention relates to a method and the apparatus for on-line diagnostics and the prediction of the dielectric behavior of power transformers.

### State of the Art

The present, most frequent diagnostic of a dielectric behavior of power transformers is based on the single reading of the dielectric strength of transformer oil, the Ud-value (e.g. kV/2.5mm). If a Ud-value is higher than the norm-defined level, the transformer can be regarded as safe and operational; if not, the transformer requires proper maintenance to increase the Ud-value over the level requested by the norm.

The reading of relevant Ud-values is a very simple, widely accepted solution which purports to have no problems. The oil is sampled from the oil filling of the main tank of the transformer under its normal operational conditions and the Ud-value is subsequently measured in the laboratory.

The test procedure is strictly defined by the norm (IEC 60 156) and the direct connection between the allowed Ud-values and the dielectric status of the transformer is defined by e.g. IEC 60 422.

General claims of any technical measuring:
○ **the repeatability** (Can I get , repeatedly, the same Ud-value by the same transformer and by the same laboratory ? )
○ **the reproducibility** ( Can I get the same Ud-value by the same transformer with other laboratories?)
should be easy achieved and consequently, after a correct evaluation and interpretation , the user must get the clear answer to two basic questions - does the oil satisfy the norm and can the given transformer be safely operated or not.

But an everyday diagnostic practice based on operative oil test results shows something quite different.

The standard procedure often give us scattered Ud-values for the same transformer even if the oil does not contain any particles or other non-homogeneities.

From the physical side, the scattering of Ud-values of the transformer is comprehensible and explainable. The dielectric strength of an arbitrary transformer oil always varies with its relative humidity and heavily depends on two variables : the water content in the oil and the temperature of the oil.

The problem is, that the major part of water in any power transformer, usually over 97-98 weight %, is typically positioned in its hard cellulose insulants as Kraft paper, boards etc, and in others cellulose-based materials as wood etc. According to the temperature of the oil-cellulose insulation system, the water migrates between cellulose-based materials and the oil filling and subsequently, the water content in the oil and the Ud-value of the oil inevitably fluctuates as well.

The real Ud-value of the oil in the specific transformer therefore generally depends on the water content in its cellulose materials and its temperature. It simply means, the Ud-value of oil has to change with the transformer temperature.

In practice, the impact of these basic facts may be very serious or even critical - the oil sampled from the same transformer under different operational temperatures gives us different Ud-values and therefore a different picture of its dielectric behavior.

The standard diagnostic approach: one sample of the oil from the transformer → one Ud-value evaluation of the oil in a lab → one diagnostics result, cannot give us the clear picture and the answer to the fundamental question: can the given transformer be safely operated or not?

Moreover, the Ud-reading of the specific transformer is not only determined by its temperature but by the dynamic change of the temperature transformer.

We will always obtain two different readings of the Ud-values at the same temperature level of a transformer, whether with decreasing or increasing temperatures.

The basic object of any relevant diagnostic is the satisfactory repeatibility and the reproducibility of all readings and evaluations. These generally cannot be met with transformers as heretofore known. The practice of oil sampling at any predefined temperature of a transformer is extremely difficult.

The dielectric strength of the oil, the Ud-value depends on:
○ Relative Humidity of the oil (RH-value) which , for given transformers permanently varies with its temperature
○ particles in the oil

If we presuppose that our oil is without particles, then the Ud-value depends only on the RH-value.

It means, the increase of a temperature of the oil means the decrease of its RH-value and the increase of its Ud-value and vice-versa.

But the increase of the temperature of the whole transformer, means the increase of the temperature of its oil-cellulose system and the migration of the water from cellulose materials into the oil filling. The increase of the water content in the oil, means the growth of the RH-value and the drop of the Ud-value.

And vice-versa - the decrease of the transformer temperature, means that there will be an increase of its Ud-values.

Both processes in any transformer proceed simultaneously and partially compensate each other. In the end-effect, the "real" Ud-value of the oil ( measured at operational temperature of its oil-cellulose system) then slightly grows with the temperature growth and sinks with its decrease. But for the "lab" Ud-value, the oil is not sampled from the oil-cellulose system at a operational temperature, but instead measured at 20 °C in the lab, which generally creates a big difference in the Ud-value.

The present methods used do not consider these facts in detail. The standard diagnostic is mainly limited to sampling the oil under arbitrary operational conditions of a transformer and subsequent evaluating the Ud-value in the lab at a predetermined temperature of 20 °C.

Theoretically this approach means :
○ the sampling of the oil is performed at an operational temperature of a transformer (which is usually much higher as 20 °C: the lab temp.)
○ the sampled oil is cooled down at 20 °C
○ the Ud-reading is performed at 20 °C
and represents de-facto a methodical error. Under standard and methodically correct conditions any parameters of an examined system must not be change by reading - it means here, the Ud-value has to be measured, at the operation temperature of the insulation system, not at lab temperature 20 °C.

A standard diagnostic procedure then doesn't represents the real behavior of the oil-cellulose insulation but describes "the worst possible case": when the oil-cellulose system is seemingly "jump-like" cooled down from the operational temperature to the lab temperature of 20 °C, the RH-value of the oil jump-like increases and its Ud-value jump-like decreases ( if we presume that the lab temperature, 20 °C, really represents the lowest achievable temperature of the system).

Only by the jump-like change of the temperature of the oil-cellulose system can the migration of the water between oil filling and the cellulose materials be stopped.

The oil-cellulose system itself behaves here as if it consists from the oil only : the temperature change is so fast, that the water from the oil filling doesn't have enough time to migrate back to the cellulose, or to diffuse back to the oil.

Upon initial examination, the jump-like cooling-down of a real transformer looks like as a pure theoretical process, but it isn't. The similar effect can be observed in any transformer. In any oil cooler of a transformer, the oil is cooled down without the presence of cellulose materials and therefore the same effect of the "jump-like" decrease of the oil temperature equals the increase of the RH-value and the jump-like decrease of the Ud-value.

The standard diagnostic Ud-approach then inevitably represents the worst possible dielectric case of a transformer.

Although this approach has its explicit advantages - it remains simple, available and widely used and if properly performed gives us some, though, mostly unquantifiable, safety reserves by the Ud-diagnostic conclusions.

But because of the strong dependency on the temperature, the main drawback of this diagnostic approach remains:
○ cold transformers, regardless of the real amount of internally deponed water, always show relatively high Ud-values: water is positioned in cellulose materials and subsequently, a low water content in the oil (at 20 °C) results in a low RH-level and high Ud-levels even in wet transformers;
○ hot transformers, on the other hand, always show relatively low Ud-values: due to higher temperatures the water migrates from the cellulose into the oil, the water content in the oil is therefore high. Though the RH-level at this operational temperature is relatively low and Ud-level relatively high, the cooling-down of the oil to 20 °C ( at the lab. temp), results in the strong increase of the RH-level and the decrease of the Ud-level, in spite of the fact that the water content of its cellulose materials can be relatively low.

The standard diagnostic results for the given transformer, if it is based on an occasional or periodic reading of a Ud- level can therefore be full of contradictions.

The same transformer, at low temperatures, satisfies norm-requested Ud-levels very well and can be operated without a problem, but on higher temperatures the Ud-value drops down and the transformer should not be operated.

The drawbacks of present off-line diagnostic methods, if they are based on occasional samplings and point-like readings of Ud-levels, can be summarized in the following way:
○ between two periodically performed sampling procedures (and Ud-readings), the user of the transformer simply don't have any relevant information about the real dielectric behavior of his transformer. Any accidental higher loading and subsequently higher temperatures of the transformer usually means the violation of the Ud-limit required by the norm;
○ single reading of the Ud-value is not sufficiently representative, because it doesn't properly respect the migration of the water between the cellulose and oil filling of a transformer, especially with dynamic changes of its temperature;
○ the standard method is not able to describe the dielectric behavior of a transformer for the whole range of its operational temperatures;
○ the method is not able to predict the dangerous operational areas of the transformer, e.g. to find the value of the break-point temperature, where the Ud-level goes under the allowed level defined by the norm.

### Disclosure of the Invention

The invention provides a method and apparatus for on-line diagnostics and the prediction of the dielectric behavior of power transformers using a TLC-relation method (Temperature Loading Curve) based on the on-line reading of the relative humidity of the oil in the main tank, and indirect on-line reading of, at least, two temperatures of the oil-cellulose system of the transformer by a suitable computer, to obtain the data which is subsequently used to evaluate one of the most important parameters of any transformer: the average water content in its cellulose materials expressed as a percentage by weight - the Qp-value, and the dielectric characteristic of the transformer, the TLC-relation which describes its dielectric behavior for the range of operational temperatures.

The importance of the Qp-value will be obvious once one considers the discussion in the present invention. This value represents the temperature invariant parameter of the transformer - the Qp-value cannot substantially change with the temperature of the given transformer. In other words, for the given transformer we have to get an approximately same Qp-value regardless of its temperature level (in a given time-period).

The temperature invariancy of the Qp-level for a given transformer is easy explainable again. As mentioned before, in the cellulose materials of any transformer more than 97% of the water is typically positioned in cellulose and only the remainder can freely migrate between its cellulose materials and its oil filling. The arbitrary change of temperature of a transformer cannot therefore induce a substantial change of the Qp-value and generate corresponding measuring error. The amount of water which can freely migrate between the cellulose and oil filling is negligible against the amount of the water positioned in the cellulose.

The introduction of the Qp-value as the temperature invariant value of the transformer therefore has enormous implications. Because independently of the temperature, the Qp-level describes and predicts the Qw-value , the RH-value for any temperature level and therefore the Ud-behavior under arbitrary operational temperature of the transformer.

The Qp-value is only an average value, which can be easily evaluated by two directly and precisely measurable variables:
○ water content in the oil, Qw (ppm)
○ average temperature of transformer T (°C)

This statement is only correct under one, but extremely important, condition. The reading of the Qw-value and T-value should be performed under acceptable equilibrium conditions - it means the Qw- and T-value doesn't substantially change for the relatively long time-period before and during the reading.

The introduction and exact quantification of the Qp-value for the transformer allows us then not only to fulfill the requested repeatability and reproducibility conditions, but also relevantly describes and predicts its dielectric behavior :
⇒ under normal operational conditions the Qp-value of a given transformer doesn't change for a relatively long time period ( at least, months) and any diagnostic lab reading has to obtain the same Qp-value at this time-period;
⇒ based on the Qp-value, the change of the Ud-value can be predicted for the whole range of operational temperatures of any given transformer;
⇒ the verification of diagnostic outputs and results is simple and convincing because it is based on the direct comparison of theoretical Ud-values with independent and direct Ud-readings from the laboratory (at the same temperature of the transformer).

In practice the new diagnostic method preferably proceeds in the following steps:
■ the RH-value of the oil is measured on-line by a suitable capacity sensor, not ballasted by any parasitic effects ( e.g. the water in organic acids present in the aged oil is not read, as it cannot migrate between the oil and the cellulose )
■ at least two temperatures of the transformer ( the bottom and the upper temperature of oil in the intake and output of oil coolers) levels are measured on-line and the averaged temperature of its oil-cellulose system, the TTS-value, is evaluated in this way
■ all measured values are continuously stored in the computer and the evaluation of equilibrium conditions of the transformer are simultaneously performed
■ when the requested equilibrium of the transformer is achieved, the sampling of the oil is recommended to obtain the Ud-value(s) for the verification of the method.

Preferably, the first step of this new method is always to evaluate the equilibrium condition of the transformer.

This process can be relatively difficult, especially by transformers operating under strong and heavy load changes. The temperature of the oil filling of the transformer fluctuates and subsequently varies the water content in the oil as well.

The proper hardware and software is necessary to find and determine the correct time-intervals of the measured data , where Qw-value and TTS-value are near constant in time. In other words, we are looking for the relatively long time-interval(s), where the migration of the water between the cellulose and oil filling is negligible and the diagnostic method based on equilibrium relations give us the relevant outputs.

According to the invention, a three step approach is used :
○ main data filtration - the data sections where the RH- or the TTS-values vary strongly in the time-period are excluded;
○ if there does not exist any suitable time-period where the RH- or TTS- values are near constant, the "active stabilization" of the transformer temperature should be performed. The desired temperature level of the temperature governor of the transformer is set gradually at a lower level, to stabilize the temperature of the transformer (and subsequently to stabilize the RH-value and Qw-value levels as well);
○ the whole field of Qp-levels are further filtrated to obtain the best, mean Qp-level of the transformer ( the mean level has to be approx. constant in the given time-period).

The third step de-facto utilizes the already mentioned fact, that the "real" Qp-level ot the transformer should be ( in the given time- period) near constant. All evaluated Qp-values which do not satisfy this conditions should be excluded.

The evaluation of the Qp-value should be based on the measured equlibrium relations or charts (Nielsen, Piper etc.), where the Qp-value is expressed as a product of a Qw-value and a TTS-value, taken under very strict equlibrium conditions.

The first step, the main data filtration, then should preferably exclude the inappropriate Qw-value and TTS-values , the second step should preferably "stabilize" the transformer and to allow us, in the third step, to evaluate the field of Qp-values and filtrate them to obtain the final Qp-value of the transformer.

The third step represents the reverse data filtration - we know that Qp-values cannot substantially change in time ( for the specific time-period) and the corresponding selection/ filtration is then relatively simple.

The next step then gives us the expert component that then generates the TLC-relation (Temperature Loading Curve) of the transformer.

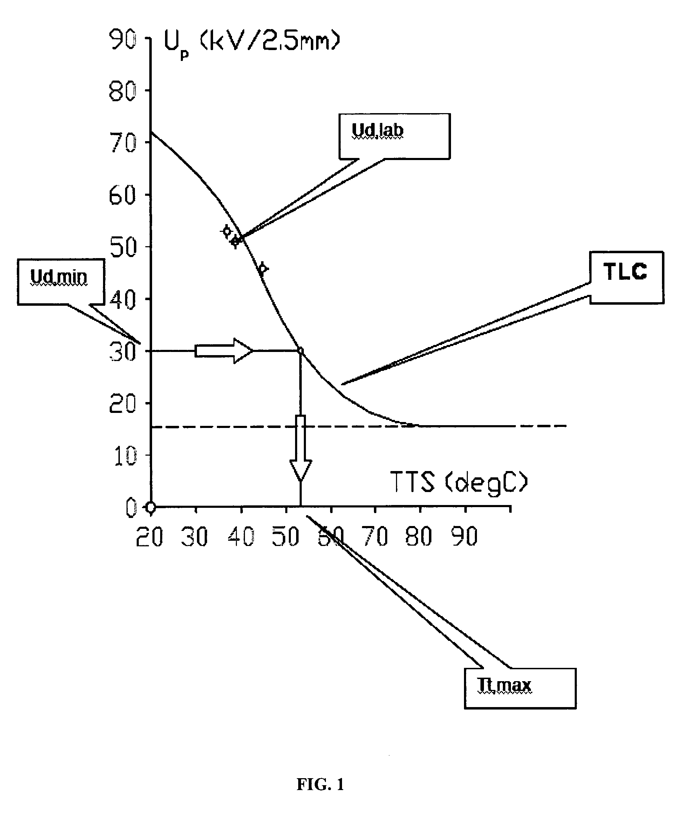

Based on the final Qp-value, the expert component calculates the water content in the oil (Qw-value), its RH-value and subsequently its Ud-value for the whole range of its operational temperature (TTS) range of the transformer (See Fig. 1).

The advantage of this approach is enormous. The TLC relation enables us to predict any Ud-value for the whole temperature range of the transformer and subsequently, the comparison of predicted and measured Ud-values enables us to easily verify the TLC relation as a whole.

The Ud-value(s) of oil used for this verification should be based on the oil sampled from the transformer at the directly measured TTS- level(s) under acceptable equilibrium conditions. This verification then consists of the quantitative comparison of the measured Ud-level(s) and the predicted Ud-value(s) for the same TTS-level(s).

If it is correctly verified, the TLC relation then allows a number of a very important diagnostic results, such as, for example : what is the maximum admissible temperature level of the transformer at the norm given minimal Ud-level (See Fig. 1), what amount of water has to be removed from the transformer to reach the requested Ud-value at the given TTS-level, the correct evaluation of the effectivity of any kind of dehydration, the monitoring of long-term changes of important parameters, the effect of particles in the oil etc. etc.

In practice, the TLC relation curve can be obtained as well. The repeated sampling of oil from the transformer (with given Qp-level) at different temperature levels (e.g. in the range from, say, 20 °C to, say, 100 °C), and by the subsequent reading of Ud-levels in the lab (at 20 °C) should give us the same curve as the predicted one.

This "field" evaluation of the TLC relation is of course very difficult because the field evaluation has to be based on a large number of oil samples at different temperatures of a transformer.

The fundamental, huge advantage of our "predictive" TLS-approach, is its ease of simplicity and verification, as opposed to the "field" evaluations which are inevitably very expensive and time-consuming.

Our approach of one reading of the Qw-value, TTS -value under sufficient equilibrium of a transformer, plus one oil sample for the subsequent verification of the TLC relation, gives us everything we need.

The on-line reading, the stabilization of the temperature of the transformer, the filtration of the data and the continuous up-dating of the TLC-relation makes the whole diagnostic process easier and more precise. The user of the transformer knows then not only the instant behavior of his transformer, but can plausibly predict its dielectric behavior under any future operational conditions.

The new method fully respects the physical relations between the oil and the cellulose and enables us to take four more important steps:
○ on-line adaptive temperature control of a transformer regarding its maximal allowed operational temperature level;
○ on-line evaluation and exclusion of potentially dangerous dynamic events e.g. the avoidance of dangerously low Ud-levels in the oil by the immediate restart of a transformer after its sudden shut-down and the correspondingly rapid cooling-down of the oil filling;
○ safe and time-optimal starting of a transformer according to the predicted and norm-requested Ud-level;
○ off-line maintenance recommendations, e.g. how much water has to removed to achieve optimal dielectric conditions of a transformer under any given or expected future loads.

The direct quantitative verification of predicted TLC-relation, enables us to make another two, very important, diagnostic conclusions: one is the estimation of the size and amount of particles in the oil and secondly the verification of the plausibility, precision and relevancy of the diagnostic processes.

If the predicted Ud-value is substantially higher than the measured one, the likely explanation of this effect is the non-homogeneity of the oil dielectricum: mechanic dirt particles are present in the oil. The size and amount of the particles then has to be checked in the laboratory to confirm or to disprove this estimation.

Contrarily, if the measured Ud-value is substantially higher than the predicted one, a serious discrepancy exists, namely that the whole measurement and evaluation process is not precise enough. The reading or the evaluation is probably distorted by a measuring error. The reason is obvious once one considers the teachings of the present invention. For the same temperature, the lab Ud- level simply cannot be substantially higher than the predicted one. The reliability of both outputs, the TLC-relation and the lab Ud-level(s) should be verified in detail.

### Brief Description of the Drawings

FIG.1 shows the TLC-relation (Temperature Loading Curve) for the given Qp-value of the transformer, where TLC is a function of the Qp-value and averaged temperature (TTS) of transformer, and shows the determination of the maximal admissible temperature of this transformer based at minimal allowed dielectric strength of the oil, the Udmin-value; and

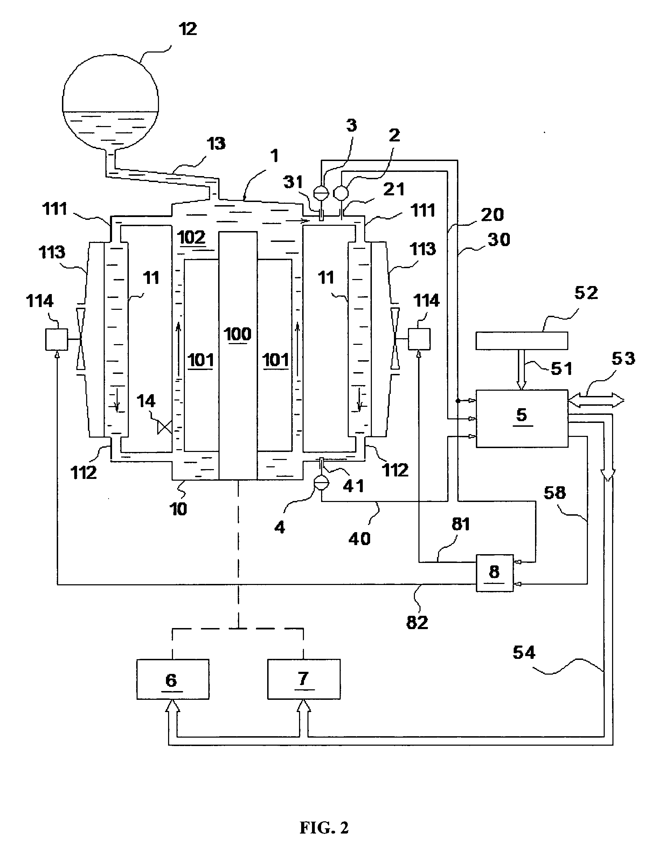

FIG.2 schematically shows the device for the on-line diagnostics and prediction of the dielectric behavior of power transformers in accordance with the invention, where the description and identification of their dielectric behavior of these transformers is based on the on-line reading of the relative humidity of the oil and at least two temperatures of this transformer under normal or actively achieved equilibrium conditions, determines their temperature invariant parameters, the Qp-values and their dielectric characteristics, the TLC-relations.

### Best Mode of Carrying out the Invention

An embodiment of the invention is shown in FIG.2, and primarily includes the transformer 1, including the main tank 10, where the magnetic circuit 100 and the winding 101 is situated. The conservator 12 is located above the main tank 10 and is connected by the connecting tube 13. The upper and the bottom part of the main tank 10 is connected by upper sleeve 111 and bottom sleeve 112 to upper and bottom part of oil coolers 11 provided by the fan casings 113 with the built-in fans 114. At the right side of the main tank 10, the upper sleeve 111 is provided with the upper well 31 and the sleeve 21, the bottom sleeve 112 is provided by the bottom well 41, and the sampling cock 14 is situated at the left side of the main tank 10.

The electrical circuits of the first practical aspect of the invention include measuring and control lines which connect the process control device 5 with the upper temperature sensor 3, moisture sensor 2 and bottom temperature sensor 4, temperature governor 8, component of safety circuits 7 , control component 6, remote PC (not shown) and the control port 52.

The temperature governor 8 is also connected to the upper temperature sensor 3 and both fans 114.

The first measuring line 30 connects the upper temperature sensor 3, inserted in the upper well 31 in the upper sleeve 111, with process control device 5 and simultaneously with the temperature governor 8; the second measuring line 20 connects the moisture sensor 2, inserted into the sleeve 21, in the upper sleeve 111; with process control device 5 and the third measuring line 41 connecting the bottom temperature sensor 4 inserted in the bottom well 41 with process control device 5.

The first data line 51 connects the control port 52 with the process control device 5, the second data line 53 connects process control device 5 with the remote PC (not shown), the third data line 54 connects process control device 5 with the control component 6 and the safety component 7 of the transformer 1 and the fourth data line 58 connects the process control device 5 with the temperature governor 8.

The first control line 81 and the second control line 82 then connects the process control device 5 with both fans 114.

The operation of the of the first embodiment of the invention (FIG.2) is focused on the on-line acquisition of two (from the view of its dielectric behavior), fundamental parameters of any transformer, its Qp- value as the temperature invariant which doesn't substantially change with the temperature and its TLC-relation which describes the dielectric strength of oil for the whole range of transformer temperatures.

The on-line approach is the continuous reading of main variables, their relevant processing, and if necessary, the active control of the working condition to achieve the requested temperature and moisture equilibrium of the transformer 1.

The moisture sensor 2, the upper temperature sensor 3 and the bottom temperature sensor 4 continuously read the given variable, and the process control device 5 saves the values of the relative humidity of the oil RH, the upper temperature of the oil Tup and the bottom temperature of the oil Tbott in the pre-defined time interval into the process control device 5 memory and calculates then the value of the water content in the oil, the Qw-value.

Simultaneously the evaluation of the equilibrium conditions of the transformer 1 is performed, and is based on the time-change of the Qw-value and Tup-variables.

If time-gradients of Qw-value and Tup-variables are smaller than pre-defined gradient criterions saved in the process control device 5, the first selection of all mentioned variables is performed to obtain the first estimation of the averaged water content in cellulose insulants, the Qp-value. Both gradient criterions can be changed manually, by the control port 52, or remotely by the PC.

This first selection in the acquired data array is based on the searching of time-intervals where time-gradients of Qw-values and Tup-variables are lower than pre-determined criterions. The whole data array is split into proper and improper time-intervals. Only proper time-intervals, where Qw-values and Tup-values are near constant, are then used for the calculation of Qp-values.

When the transformer 1 operates in the dynamic operation mode, where Qw-values and Tup-values vary strongly and there are unavailable proper time-intervals, where both variables are near constant, the Qp-value processing makes no sense because the relevant evaluation of a Qp-value is substantially always strictly based on equilibrium conditions.

This operation mode of the transformer 1 corresponds to the situation where the desired temperature level of the temperature governor 8 is set to a relatively high level over the maximum operational temperature of its oil filling. The forced cooling of the transformer 1, performed by fans 114, is therefore switched off and the transformer temperature freely fluctuates with the load.

Any dynamic change of the transformer load or the surrounding temperature then inevitably induces strong variations in the Tup-value and consequently variations in the Qw-value of the oil.

In this case, the active stabilization of the temperature of the transformer is necessary. According to the invention, the process control device 5, by means of the fourth data line 58, gradually decreases the setting value of the temperature governor 8 until this level drops under the Tupp- level and then the temperature governor 8 switches on both fans 114 .

The cooling effect induced by the forced blowing of oil coolers 11 substantially increases the heat removal from the transformer 1 and its temperature gradually decreases.

The temperature stabilization of the transformer is continuously evaluated by process control device 5, which gradually modifies the setting level of the temperature governor 8 to reduce the maximum amplitude of the Tup-variable under cca 2-4 °C.

The temperature control of the transformer 1 shown here is an example only. The real temperature control loop of the transformer 1 and its function is simplified for clarity and a better understanding.

The practical temperature control loop is substantially more sophisticated because has to handle multiparametric problems. The load of the transformer 1 and the surrounding temperature fluctuate and the proper stabilization of the Tup-level needs an adaptive control.

The temperature stabilization of the transformer 1 always results in the substantial improvement of the Qp- specification. The Tup-temperature now fluctuates around its steady- state value with higher frequency and substantially lower amplitude which boosts a periodical micro-migration of the water between the cellulose and oil filling of the transformer 1 and accelerates the state of virtual equilibrium.

The time-intervals with small Tup- and Qw-gradients become longer and longer and the subsequent calculations of Qp-values give us a smaller, but more relevant group of Qp-values with substantially smaller variances.

For further improvement of the precision and the verification of the mean Qp-value of the transformer 1, the reverse filtration of the data is used. As mentioned before, the reverse filtration of the Qp-group is based on the fact, that the actual Qp-value of a transformer cannot considerably change with its temperature.

The averaged Qp- value from all proper time-intervals is evaluated. Subsequently, all Qp-values with higher deviations are filtered out, new averaged Qp-value is calculated and this process is repeated until the Qp-deviations are as small as requested.

The mean Qp-value acquired this way , is then used for the generation of the TLC-relation. The TLC-relation is then quantitatively verified by at least one Ud,lab- value(s), See FIG1.

The Ud,lab-reading(s) should be based only on the proper sampling procedure. The sampling from the oil filling 102 of transformer via sampling cock 14, has to be strictly time-determined and only the Ud, lab-values of oil sampled under equilibrium conditions are used to avoid any systematic errors.

When, for the same time-period, the TLC- predicted Up-values are significantly different from the Ud,lab-values , this discrepancy is evaluated by the process control device 5 as a measuring error and this information is transferred via the second data line 53 to the user's PC .

The user immediately obtains the relevant information about sources of potential measuring errors.

All necessary steps to improve the precision and the verification of the whole diagnostic procedure beginnings with the checking of the sensors, the evaluation their outputs etc. The PC then proposes the correct steps to be taken.

Only if the TLC-verification is successful can any further diagnostic steps be made.

The minimum allowed dielectric strength the Ud,min-value is then used to calculate the Tt,max - value, the maximum admissible averaged temperature of the transformer, see FIG.1.

The first estimation of the presence, size and amount of particles in the oil can then be performed etc.

The process control device 5 then correspondingly upgrades via the third data line 54 the setting of the safety component 7 and the control component 6 of the transformer 1.

## Claims

1. The method of the on-line diagnostics, prediction and optimization of the dielectric behavior of power transformers,
**characterized in that,** in the upper part of the transformer (1) the relative oil humidity and the oil temperature are measured continuously, said temperature representing the highest one of the insulating oil-cellulose system of said transformer,
and in the bottom part of the transformer (1) the oil temperature is measured, said temperature representing the lowest one of the insulating oil-cellulose system of said transformer, and the relative oil humidity and both temperatures are measured periodically by means of the process control device (5) and the temperature value in the upper part of the transformer (1) is also transferred to the temperature governor (8) of the transformer (1),
and the process control device (5) stores the measured values in its memory in defined time intervals and compares the time changes thereof to entered criteria, and evaluates the requested concentration and thermal equilibrium of the transformer (1),
and if said equilibrium exceeds the range of the requested concentration and thermal equilibrium, the requested temperature value of the transformer (1) on the temperature governor (8) of said transformer is reset by means of the process control device (5) so that the transformer (1) may reach the requested thermal equilibrium and then the concentration equilibrium due to the change of its cooling regime, and after reaching the requested equilibrium conditions in the transformer (1), the value of the mean water content in cellulose-based materials of the transformer (1) is calculated from the equilibrium relation between the water content in the cellulose, the calculated water content in the oil, and the average temperature of the transformer (1), and said mean water content is stored in the memory of the process control device (5), and further the average water content value is compared to the values gained from preceding measurements, with the credibility of this value being verified on the basis of the entered criterion provided the theoretical course of the transformer oil dielectric strength is generated with the process control device (5), on the basis of the mean water content in cellulose-based materials, as a function of the mean temperature of the given transformer (1) for the whole extent of operational temperatures thereof, and this curve, expressing the dielectric behavior of the transformer (1) in the whole range of operating temperatures thereof, is then verified quantitatively by means of one oil dielectric strength value at least which has been obtained by independent measurement in a laboratory.

2. The method of the on-line diagnostics, prediction and optimization of the dielectric behavior of power transformers according to the Claim 1, **characterized in that,** the maximum allowable temperature of the transformer (1) is determined on the basis of the obtained and verified dependence of the oil dielectric strength on the mean temperature of the transformer (1) and of the entered requested minimum dielectric strength value of this oil and the value of this quantity is used to set the protections of the transformer (1).

3. The method of the on-line diagnostics, prediction and optimization of the dielectric behavior of power transformers according to the Claims 1 and 2, **characterized in that,** the dynamic response of the transformer oil dielectric strength on fast changes of the temperature of the transformer (1) is simulated on the basis of the determined and verified values of the mean water content in the cellulose-based materials of the transformer (1) and the minimum value of this response is compared to the minimum allowable oil dielectric strength value and then the allowable trends are calculated for loading, starting up and putting out of operation of the transformer (1) with this information being transferred in the control block (6) of the transformer (1) where it is used to block and control processes which could cause dynamic drop of the oil dynamic strength under permitted values and decreasing of the operational reliability of the transformer (1) due to it, too.

4. A device to perform the method of the on-line diagnostics, prediction and optimization of the dielectric behavior of power transformers, said device consisting of the transformer (1) to which the oil humidity sensor (2), the upper temperature sensor (3), the bottom temperature sensor (4), the process control device (5), the control block (6), the safety block (7), and the temperature governor are connected, **characterized in that,** in the main tank (10) the active part of the transformer (1) is located, said active part consisting of the winding (101) and the magnetic circuit (100) and being immersed in the transformer oil filling (102),
and the upper part of the main tank (10) is connected to the conserver (12) by means of the connecting tube (13) whereas the oil cooler (11) is connected to the left and right parts of the main tank (10) by means of the upper sleeve (111) and the bottom sleeve (112), with the cooler casing (113), equipped with the fan (114), being connected to said oil cooler (11), and on the left side the main tank (10) of the transformer (1) is equipped with the sampling cock (14)
where the upper well (31) of the upper temperature sensor (3) and the sleeve (21) of the oil humidity sensor (2) are installed in the right upper sleeve (111)
and the upper temperature sensor (3) is interconnected to the input of the process control device (5) by means of the first measuring line (30) and the bottom temperature sensor (4) is interconnected to the input of the process control device (5) by means of the third measuring line (40), with said temperature sensor (4) being located in the bottom well (41) installed in the bottom sleeve (112),
and the oil humidity sensor (2), located in the sleeve (21), is also connected to the input of the process control device (5) by means of the second measuring line (20), **whereas** the output of the process control device (5) is connected to the control port (52) by means of the first data line (51), to the superior control computer by means of the second data line (53), to the safety block (7) and to the control block (6) of the transformer (1) by means of the third data line (54), and to the input of the temperature governor (8) by means of the fourth data line (58), with the upper temperature sensor (3) being connected to the said input of the temperature governor (8) by means of the first measuring line (30), the output of the temperature governor (8) is connected to the fans (114) by means of the first control line (81) and the second control line (82).
